# EUROPÄISCHE PATENTSCHRIFT

(11) **EP 2 593 994 B1**
(45) Veröffentlichungstag und Bekanntmachung des Hinweises auf die Patenterteilung: **29.03.2017**
(21) Anmeldenummer: 11738623.5
(22) Anmeldetag: 15.07.2011
(51) Int. Cl.: H01R 13/627, H01R 13/502, H01R 13/506, H01R 43/26, H05K 5/00

(54) **GEHÄUSE, INSBESONDERE FÜR EINEN ELEKTRISCHEN KABELANSCHLUSS**
HOUSING, IN PARTICULAR FOR AN ELECTRICAL CABLE CONNECTION
BOÎTIER, EN PARTICULIER POUR UN CONNECTEUR DE CÂBLE ÉLECTRIQUE

(30) Priorität: 16.07.2010 DE 102010027524
(43) Veröffentlichungstag der Anmeldung: 22.05.2013
(73) Patentinhaber: Phoenix Contact GmbH & Co. KG, 32825 Blomberg (DE)
(72) Erfinder: FEYE-HOHMANN, Jürgen, 32756 Detmold (DE)
(74) Vertreter: Muth, Bruno
(86) Internationale Anmeldenummer: PCT/EP2011/003579
(87) Internationale Veröffentlichungsnummer: WO 2012/007180

(56) Entgegenhaltungen:
- EP-A1- 0 585 633
- US-A- 3 133 777
- US-A- 5 620 330

## Beschreibung

Die vorliegende Erfindung betrifft ein Gehäuse, welches insbesondere für elektrische Kabelanschlüsse geeignet ist und welches zwei miteinander verbindbare Gehäuseteile aufweist. Das Gehäuse kann bei den unterschiedlichsten Typen von elektrischen Kabelanschlüssen angewendet werden. Möglich und bevorzugt ist auch der Einsatz bei Gehäusen für Kabelanschlüsse für Photovoltaikanlagen, um die Solarkabel einzelner Module von Photovoltaikanlagen über elektrische Kabelanschlüsse miteinander zu verbinden.

Im Stand der Technik sind verschiedenste Gehäuse für elektrische Kabelanschlüsse bekannt geworden, die zwei oder mehr Gehäuseteile aufweisen und die miteinander verbindbar und insbesondere verrastbar ausgebildet sind. Solche Gehäuse sind z. B. aus der US 3 133 777 A, aus der EP 0585 633 A1 und aus der US 5 620 330 A bekannt. Zur Verbindung der Kunststoffteile eines Gehäuses ist die Verrastung eine kostengünstige Möglichkeit, da Schrauben und zusätzliche Bauteile nicht erforderlich sind. Weiterhin ist die Montage einfach und auch für automatisierte Prozesse gut geeignet.

Üblich ist die Verwendung von Rasthaken, an deren Ende eine Nase angebracht ist. Aufgrund parallel versetzter Kraftwirkungslinien kann es hier zu einem Drehmoment kommen, welches bei großen Kräften zu einem Aufbiegen der miteinander verrastenden Flächen führt, wodurch sich die Verbindung bei großen Kräften selbsttätig lösen kann.

Vor diesen Hintergrund ist es die Aufgabe der vorliegenden Erfindung, ein Gehäuse für elektrische Kabelanschlüsse zur Verfügung zu stellen, welches zwei miteinander verbindbare Gehäuseteile aufweist und welches einfach zu montierten ist und sich nicht selbsttätig wieder öffnet.

Diese Aufgabe wird gelöst mit einem Gehäuse mit den Merkmalen des Anspruchs 1. Bevorzugte Weiterbildungen sind Gegenstand der Unteransprüche. Weitere Vorteile und Merkmale ergeben sich aus den Ausführungsbeispielen.

Ein erfindungsgemäßes Gehäuse ist insbesondere für den Einsatz an elektrischen Kabelanschlüssen vorgesehen und weist wenigstens zwei miteinander verbindbare Gehäuseteile auf. Jedes Gehäuseteil weist jeweils wenigstens einen Verbindungsabschnitt auf, wobei ein erstes Gehäuseteil einen als Einsteckabschnitt ausgebildeten Verbindungsabschnitt aufweist. Der Einsteckabschnitt weist dabei eine von einem runden Querschnitt abweichende Querschnittsform auf. Ein zweites Gehäuseteil weist einen als Aufnahmeabschnitt ausgebildeten Verbindungsabschnitt auf. An dem Aufnahmeabschnitt ist eine Einstecköffnung vorgesehen. Der Aufnahmeabschnitt weist einen rundlichen Querschnitt auf. Zur Herstellung der Verbindung der beiden Gehäuseteile ist der Einsteckabschnitt des ersten Gehäuseteils in die Einstecköffnung des zweiten Gehäuseteils einführbar. Im eingeführten Zustand umgibt der Aufnahmeabschnitt den Einsteckabschnitt radial und axial vollständig und formschlüssig. Es sind an den Verbindungsabschnitten Verrastungsmittel vorgesehen, welche Rastnasen und Rastöffnungen umfassen, die miteinander wirken und im Verbindungszustand formschlüssig ineinander greifen. Zur Herstellung des Verbindungszustands ist der Aufnahmeabschnitt wenigstens teilweise elastisch verformbar.

Das erfindungsgemäße Gehäuse hat viele Vorteile. Ein erheblicher Vorteil des erfindungsgemäßen Gehäuses besteht darin, dass die formschlüssig aneinander aufgenommenen Verbindungsabschnitte sich vollständig umgeben und somit eine Selbstabstützung des Einsteckabschnitts realisiert wird. Der den Einsteckabschnitt umgebende Aufnahmeabschnitt umgibt den Einsteckabschnitt vollständig und bleibt somit auch bei hohen axialen Kräften formbeständig. Der Aufnahmeabschnitt ist dabei hohl ausgebildet und nimmt den Einsteckabschnitt formschlüssig und verliersicher auf, sodass eine feste und sichere Verbindung gewährleistet wird. Dabei nimmt der Aufnahmeabschnitt den Einsteckabschnitt in radialer und axialer Richtung formschlüssig auf, sodass ohne elastische Verformung des Aufnahmeabschnitts kein Lösen oder Herstellen der Verbindung möglich ist.

In bevorzugten Weiterbildungen ist die Verrastung spielfrei. Die Rastnasen können als Rasthaken ausgebildet sein, während die Rastöffnungen als Rastlöcher oder Rastvertiefungen ausgebildet sein können. Die Rastöffnungen umgeben die Rastnasen bzw. die Rasthaken vollständig.

Vorzugsweise umfasst der Aufnahmeabschnitt eine den Einsteckabschnitt umgebende Wand aus einem elastischen Material. Die den Einsteckabschnitt im Verbindungszustand umgebende äußere Wand umgibt den Einsteckabschnitt radial vollständig, während die Verrastungsmittel an dem inneren und äußeren Verbindungsabschnitt bzw. dem Einsteckabschnitt und dem Aufnahmeabschnitt im Verbindungszustand verliersicher ineinander greifen.

In bevorzugten Weiterbildungen umgibt der Aufnahmeabschnitt den Einsteckabschnitt konzentrisch. Besonders bevorzugt ist es, dass der Aufnahmeabschnitt den Einsteckabschnitt mit einem radialen Abstand umgibt. Ein solcher radialer Abstand gewährleistet, dass bei einer elastischen Verformung das Herstellen oder Lösen der Verbindung auf einfache Weise möglich ist.

Der Einsteckabschnitt weist vorzugsweise eine abgeflachte Kreisform als Querschnitt auf. Dazu sind die Endbereiche in Richtung der maximalen Ausdehnung abgerundet ausgebildet, während seitliche Bereiche abgeflacht ausgebildet sind. Die Form der Endbereiche ist vorzugsweise an die Innenkontur des Aufnahmeabschnitts angepasst, sodass der Einsteckabschnitt vorzugsweise dicht an der Innenwandung des Aufnahmeabschnitts anliegt. Wird der Aufnahmeabschnitt elastisch verformt und an den Abflachungen zusammen gepresst, verformt sich der Innenraum des Aufnahmeabschnitts elliptisch und der Einsteckabschnitt kann eingeführt oder wieder entnommen werden.

In bevorzugten Ausgestaltungen ist wenigstens eine Rastnase an dem Einsteckabschnitt vorgesehen und nach außen abstehend ausgebildet. Wenigstens eine Rastöffnung ist an dem Aufnahmeabschnitt vorgesehen. Dabei wirken im Verbindungszustand die Rastnase des Einsteckabschnitts mit der Rastöffnung des Aufnahmeabschnitts zusammen.

Erfindungsgemäß weist der Aufnahmeabschnitt einen rundlichen oder vorzugsweise sogar runden Querschnitt auf und der Einsteckabschnitt weist eine von einem runden Querschnitt abweichende Querschnittsform auf. Anstelle des runden Querschnitts des Aufnahmeabschnitts ist insbesondere auch ein mehreckiger Querschnitt möglich und bevorzugt. Durch das Zusammenwirken des rundlichen Querschnitts des Aufnahmeabschnitts und der von einem runden Querschnitt abweichenden Querschnittsform des Einsteckabschnitts wird ein einfaches Öffnen und Herstellen des Verbindungszustandes ermöglicht.

Dazu weist in einer bevorzugten Weiterbildung im elastischen Verformungszustand der Innenumfang des Aufnahmeabschnitts eine größere Länge auf als die Länge einer Umhüllenden des Einsteckabschnitts, wobei die Umhüllende wenigstens eine Rastnase des Einsteckabschnitts umhüllt. Wenn beispielsweise der Aufnahmeabschnitt einen runden Querschnitt aufweist und der Einsteckabschnitt einen Querschnitt aufweist, der aus einem runden Querschnitt und davon abstehenden Rastnasen zusammengesetzt ist, so bedeutet dass, dass der Innenumfang des kreisförmigen Aufnahmeabschnitts eine größere Länge aufweist, als die Umfangslänge einer Ellipse, die den Einsteckabschnitt mit den Rastnasen umhüllt. Dabei ist die lange Achse der Ellipse durch die Rastnasen ausgerichtet und die kurze Achse der Ellipse erstreckt sich quer oder sogar senkrecht dazu. Bei einer solchen Ausgestaltung kann durch eine elastische Verformung der Wandung des Aufnahmeabschnitts der Querschnitt des Aufnahmeabschnitts an den Querschnitt der Umhüllenden des Einsteckabschnitts angepasst werden. Dadurch, dass die Länge des elastisch verformten Innenumfangs des Aufnahmeabschnitts größer ist als die Umfangslänge der Umhüllenden des Einsteckabschnitts kann nach der elastischen Verformung der Einsteckabschnitt aus den Aufnahmeabschnitt herausgezogen werden, da die Verrastung der Rastnasen mit den Rastöffnungen aufgehoben wurde.

Zum Einstecken des Einsteckabschnitts in den Aufnahmeabschnitt wird die Wandung des Aufnahmeabschnitts wieder elastisch verformt, sodass der freie Querschnitt des Aufnahmeabschnitts an den Querschnitt der Umhüllenden des Einsteckabschnitts angepasst ist. Da der Innenumfang des elastisch verformten Aufnahmeabschnitts größer ist als die Länge der Umhüllenden des Einsteckabschnitts kann somit der Einsteckabschnitt in den Aufnahmeabschnitt eingeführt werden. Wenn der Druck zur elastischen Verformung des Aufnahmeabschnitts nicht mehr aufgebracht wird, verformt sich der elastisch verformte Aufnahmeabschnitt in seine Grundstellung zurück, wobei die Rastnasen des Einsteckabschnitts an den Rastöffnungen des Aufnahmeabschnitts verrasten, sodass eine formschlüssige Verbindung des Einsteckabschnitts an dem Aufnahmeabschnitt vorliegt.

Vorzugsweise sind wenigstens zwei gegenüberliegende Rastnasen und zwei gegenüberliegende Rastöffnungen vorgesehen.

In einer bevorzugten Weiterbildung ist eine Summe eines maximalen Durchmessers des Einsteckabschnitts durch die Rastnase und eines Durchmessers eines Einsteckabschnitts quer dazu kleiner als der doppelte freie Durchmesser des Aufnahmeabschnitts. Das bedeutet, dass in dieser bevorzugten Weiterbildung der durchschnittliche Durchmesser des Einsteckabschnitts kleiner ist als der Durchmesser des Aufnahmeabschnitts. Insbesondere bei kleinen elastischen Verformungen aus der Kreisform in eine elliptische Form hinein, entspricht der Umfang einer Ellipse in erster Näherung etwa dem Umfang eines Kreises mit dem mittleren Durchmesser der Ellipse. Das bedeutet, dass ein kreisförmiger Aufnahmeabschnitt einen Durchmesser aufweisen muss, der etwas größer ist als der mittlere Durchmesser eines elliptischen Einsteckabschnitts, damit der Aufnahmeabschnitt so elastisch verformbar ist, dass der elliptische Einsteckabschnitt in den Aufnahmeabschnitt eingeführt werden kann.

In einer anderen Ausgestaltung ist es auch möglich, dass die Rastnasen an dem Aufnahmeabschnitt vorgesehen sind, während an dem Einsteckabschnitt Rastöffnungen vorgesehen sind. Dann kann der Aufnahmeabschnitt beispielsweise grundsätzlich einen kreisförmigen freien Querschnitt aufweisen, in den die Rastnasen von außen hineinragen. Der Einsteckabschnitt kann wiederum einen entsprechend kleineren kreisförmigen Querschnitt aufweisen und in seiner Außenwandung die Rastöffnungen zur Aufnahme der Rastnasen im Verbindungszustand aufweisen. Dabei weist der Aufnahmeabschnitt im Grundzustand einen minimalen Durchmesser auf, der kleiner ist als der Außendurchmesser des Einsteckabschnitts, während ein maximaler Durchmesser des Aufnahmeabschnitts größer ist als der maximale Außendurchmesser des Einsteckabschnitts. Durch eine elastische Verformung des Aufnahmeabschnitts wird der freie Aufnahmebereich zwischen den Rastnasen des Aufnahmeabschnitts vergrößert, sodass der beispielsweise mit einem kreisförmigen Querschnitt versehene Einsteckabschnitt in den Aufnahmeabschnitt einführbar ist. Wenn nun die Kraft zur elastischen Verformung des Aufnahmeabschnitts nicht mehr aufgebracht wird, federt der elastisch ausgebildete Aufnahmeabschnitt in seiner Grundposition zurück und die Rastnasen des Aufnahmeabschnitts greifen in die Rastöffnungen des Einsteckabschnitts ein und stellen somit eine formschlüssige und verliersichere Verbindung zwischen den beiden Gehäuseteilen her.

Um das Lösen der beiden Gehäuseteile voneinander zu erleichtern, kann wenigstens eine Rastnase und/oder eine Rastöffnung eine Schräge aufweisen. Ist die Schräge beispielsweise an der Rastnase vorgesehen, so führt ein Drehen der Verbindungsabschnitte gegeneinander in Richtung der Schräge dazu, dass der Aufnahmeabschnitt sich elastisch verformt und somit der Einsteckabschnitt aus dem Aufnahmeabschnitt herausgezogen werden kann. Ist die Schräge nur an einer Seite der Rastnase bzw. der Rastöffnung vorgesehen, so kann nur durch Drehen in eine Richtung eine Öffnung bewirkt werden, während ein Drehvorgang in die andere Richtung nur zu einem gemeinsamen Rotieren beider Gehäuseteile führt.

In allen Ausgestaltungen kann der Einsteckabschnitt oder der Aufnahmeabschnitt als Gehäusedeckel ausgebildet sein.

Weitere Vorteile und Merkmale der Erfindung werden im Folgenden in den Ausführungsbeispielen erläutert, welche mit Bezug auf die beiliegenden Figuren geschildert wird.

In den Figuren zeigen:
- Fig. 1: eine perspektivische Ansicht des Gehäuses im Verbindungszustand;
- Fig. 2: eine perspektivische Ansicht des Gehäuses beim Verbinden der Gehäuseteile;
- Fig. 3: einen schematischen Quer- und Längsschnitt;
- Fig. 4: eine schematische Darstellung des Einsteckabschnitts;
- Fig. 5: einen schematischen Quer- und Längsschnitt beim Verbinden der beiden Gehäuseteile;
- Fig. 6: eine perspektivische Ansicht des Einsteckabschnitts;
- Fig. 7: den Einsatz eines Werkzeugs beim Verbinden der Gehäuseteile;
- Fig. 8: eine weitere Ausführungsform eines erfindungsgemäßen Gehäuses.

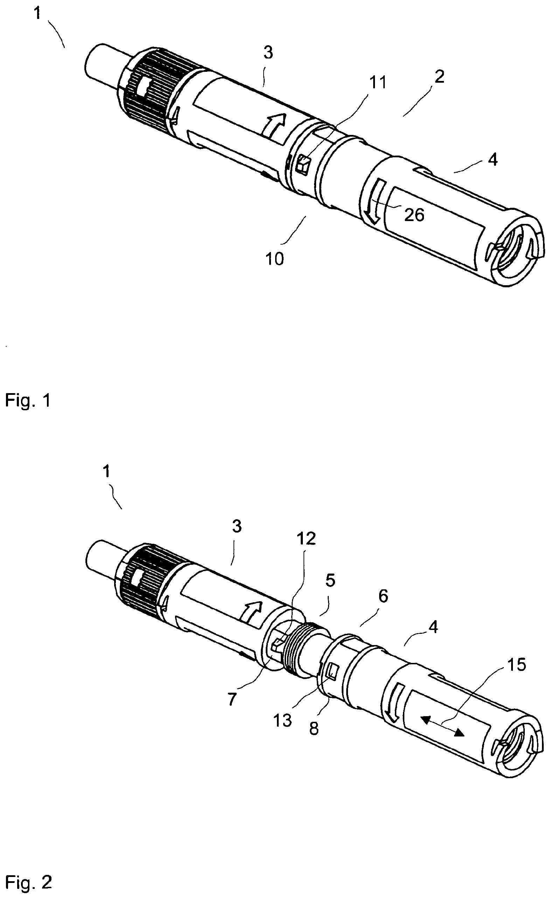

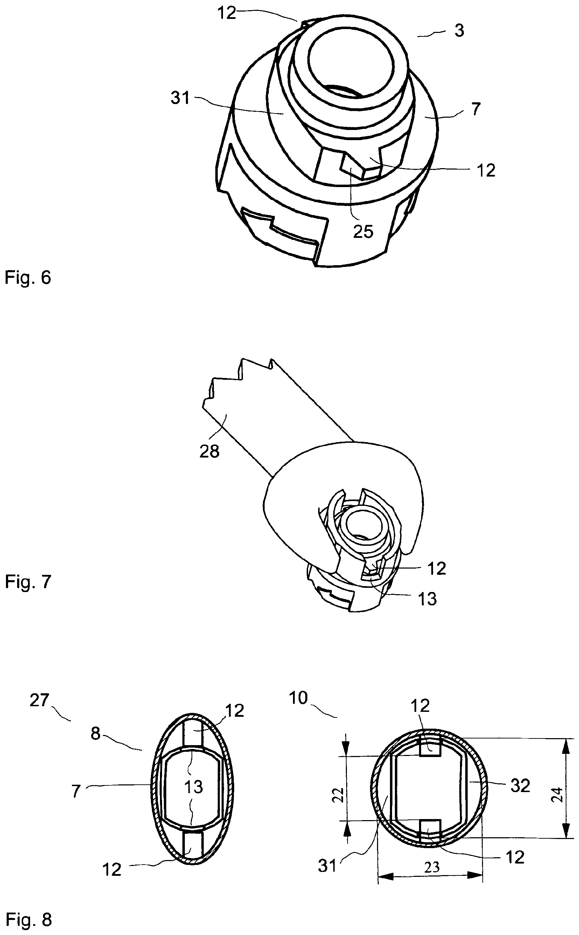

Mit Bezug auf die Figuren 1 bis 7 wird ein erstes Ausführungsbeispiel und mit Bezug auf die Figur 8 ein weiteres Ausführungsbeispiel der vorliegenden Erfindung beschrieben.

In Figur 1 ist ein erfindungsgemäßes Gehäuse 1 im Verbindungszustand 10 dargestellt. Das Gehäuse 1 dient als elektrischer Kabelanschluss 2 und weist zwei Gehäuseteile 3 und 4 auf, die im dargestellten Verbindungszustand 10 verliersicher und formflüssig miteinander verbunden sind.

Das Gehäuseteil 3 weist Verrastungsmittel 11 in Form von Rastnasen 12 auf, während das Gehäuseteil 4 Verrastungsmittel 11 in Form von Rastöffnungen 13 umfasst, die im Verbindungszustand 10 formschlüssig ineinander greifen.

Figur 2 zeigt eine perspektivische Darstellung des Gehäuses 1 beim Herstellen des Verbindungszustands 10, wobei der als Einsteckabschnitt 7 ausgeführte Verbindungsabschnitt 5 des Gehäuseteils 3 noch nicht vollständig in den als Aufnahmeabschnitt 8 ausgeführten Verbindungsabschnitt 6 des Gehäuseteils 4 eingeführt wurde.

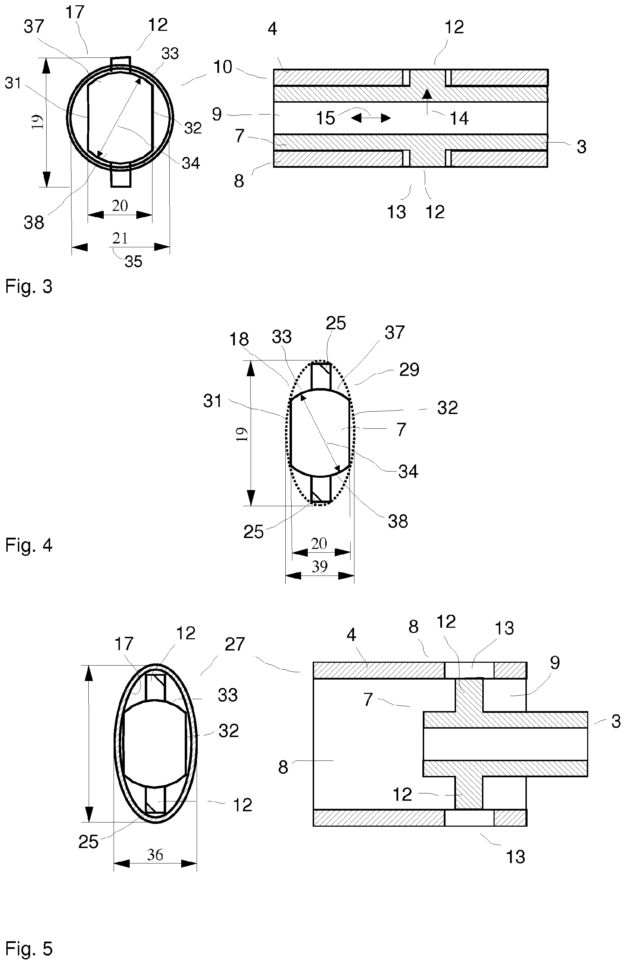

Figur 3 zeigt in einer schematischen Darstellung einen Querschnitt und einen Längsschnitt durch das Gehäuse 1 mit den Gehäuseteilen 3 und 4 im Verbindungszustand 10. Der in Figur 3 weiter rechts abgebildete schematische Längsschnitt zeigt den Einsteckabschnitt 7 des Gehäuseteils 3, der an der Einstecköffnung 9 des Aufnahmeabschnitts 8 des zweiten Gehäuseteils 4 aufgenommen ist. Dabei greifen die Rastnasen 12, die radial nach außen von dem Einsteckabschnitt 7 hervorstehen, in entsprechende Rastöffnungen 13 des Aufnahmeabschnitts 8 ein und werden dort formschlüssig und verliersicher gehalten. Dabei umgibt der äußere Verbindungsabschnitt 6 bzw. der Aufnahmeabschnitt 8 den inneren Verbindungsabschnitt 5 bzw. Einsteckabschnitt 7 in radialer Richtung vollständig, sodass die Rastnasen 12 in Umfangsrichtung 26, in axialer Richtung 15 und auch in radialer Richtung 14 formschlüssig und verliersicher aufgenommen sind.

Zwischen dem Außendurchmesser des Einsteckabschnitts 7 und dem freien Innendurchmesser des Aufnahmeabschnitts 8 kann an den Seiten mit den Abflachungen 31 und 32 ein radialer Abstand vorgesehen sein, der in Verbindung mit der elastischen Verformbarkeit des Aufnahmeabschnitts 8 für eine einfache Montage und Demontage des Gehäuses 1 sorgt.

Dabei sind die Abmessungen des Einsteckabschnitts 7 und des Aufnahmeabschnitts 8 so bemessen, dass der hier im Wesentlichen rund und mit gegenüber liegenden Abflachungen 31 und 32 ausgebildete Einsteckquerschnitt mit seinem Außendurchmesser 34 einen gleichen oder leicht kleineren Durchmesser aufweist als der freie Innendurchmesser 21 des Aufnahmeabschnitts 8. Der freie Innendurchmesser 21 entspricht hier dem rund ausgebildeten Innendurchmesser 35. Der maximale Außendurchmesser 19 des Einsteckabschnitts 7 durch die Rastnasen 12 ist hingegen größer als der freie Innendurchmesser 21 des Aufnahmeabschnitts 8. Der Einsteckabschnitt 7 liegt mit den abgerundeten Endbereichen 37 und 38 von innen dicht oder mit nur sehr geringem Spiel an dem Innenumfang 17 des Aufnahmeabschnitts 8 an. Der Radius 33 der Endbereiche 37 und 38 entspricht dem Radius des im Verbindungszustand zylindrisch ausgebildeten Aufnahmeabschnitts 8.

Dadurch, dass die Rastnasen 12 des Einsteckabschnitts 7 radial nach außen durch die Rastöffnungen 13 des Aufnahmeabschnitts 8 hindurch stehen ist der Einsteckabschnitt 7 und somit das Gehäuseteil 3 formschlüssig und verliersicher an dem Gehäuseteil 4 aufgenommen.

Figur 4 zeigt eine schematische Darstellung des Einsteckabschnitts 7, an dessen Umfang hier radial nach außen die Rastnasen 12 abstehen. Der Außenumfang des Einsteckabschnitts 7 kann vereinfacht durch eine Umhüllende 29 beschrieben werden, die hier als Ellipse eingezeichnet ist und die über einen maximalen Durchmesser 19 und einen minimalen Durchmesser 39 verfügt. Gegebenenfalls kann der minimale Durchmesser 39 dem Durchmesser 20 an den Abflachungen 31, 32 entsprechen, obwohl er in Fig. 4 etwas größer eingezeichnet ist. Schrägen 25 an den Rastnasen 12 können ein Öffnen ohne Werkzeug ermöglichen.

Figur 5 zeigt den Öffnungszustand 27 beim Herstellen oder wieder Öffnen der Verbindung der beiden Gehäuseteile 3 und 4, wenn z.B. ein hier nicht eingezeichnetes Werkzeug den Aufnahmeabschnitt zusammendrückt. Erkennbar ist, dass der Innenumfang 17 des Aufnahmeabschnitts 8 eine gleiche oder etwas größere Innenumfangslänge aufweist als die Umfangslänge der Umhüllenden 29 des Einsteckabschnitts 7. Dadurch kann durch eine elastische Verformung des Aufnahmeabschnitts 8 zu einer elliptischen Form, wie sie in Figur 5 dargestellt ist, die Verrastung der Rastnasen 12 an den Rastöffnungen 13 aufgehoben werden, sodass der Einsteckabschnitt 7 aus dem Aufnahmeabschnitt 8 entfernbar ist, wo durch die beiden Gehäuseteile 3 und 4 des Gehäuses 1 wieder voneinander getrennt werden.

Im rechten Teil der Figur 5 ist ein Längsschnitt dargestellt, der zeigt, dass die Rastnasen 12 in diesem elastischen Verformungszustand bzw. Öffnungszustands 27 vollständig innerhalb des freien Querschnitts des Aufnahmeabschnitts 8 angeordnet sind, wodurch ein axiales Herausnehmen des Verbindungsabschnitt 7 ermöglicht wird.

Figur 6 zeigt eine vergrößerte perspektivische Ansicht des Einsteckabschnitts 7, wobei zwei Rastnasen 12 an gegenüberliegenden Stellen radial nach außen abstehen. An den Rastnasen 12 ist hier auf einer Seite jeweils eine Schräge 25 angeordnet, die im Verbindungszustand 10 dazu führt, dass bei einer Drehung des Einsteckabschnitts 7 in Richtung der Schrägen ein automatisches Öffnen des Aufnahmeabschnitts 8 erzielt wird, da durch die Schräge 25 bedingt, sich der Aufnahmeabschnitt elastisch verformt und somit zu einem leichten Lösen der beiden Gehäuseteile führt. An den Seiten sind die Abflachungen 31 und 32 vorgesehen, die eine elastische Verformung des Aufnahmeabschnitts 8 ermöglichen, wenn der Einsteckabschnitt 7 spielfrei oder doch spielarm an dem Aufnahmeabschnitt 8 aufgenommen ist. Dabei wird die Form der Abflachungen 31 und 32 and die Höhe der Rastnasen 12 angepasst.

Figur 7 zeigt eine typische Möglichkeit für die Montage eines solchen Gehäuses mittels eines Werkzeugs 28, welches beispielsweise als Schraubenschlüssel oder Rohrzange oder dergleichen ausgebildet ist. Der Aufnahmeabschnitt 8 wird elastisch verformt, wodurch der Einsteckabschnitt in den freien Querschnitt des Aufnahmeabschnitts eingeführt werden kann. Nachdem das Werkzeug 28 von dem Aufnahmeabschnitts 8 entfernt wird, bildet sich die elastische Verformung des Aufnahmeabschnitts 8 zurück und der Aufnahmeabschnitt 8 nimmt seine hier ursprünglich runde Querschnittsform wieder ein. Dabei treten die Rastnasen 12 des Einsteckabschnitts 7 durch die Rastöffnungen 13 des Aufnahmeabschnitts 8 hindurch und fixieren das Gehäuseteil 3 an dem Gehäuseteil 4 in axialer Richtung und auch in Umfangsrichtung. Gleichzeitig liegen die Endbereiche 37 und 38 des Einsteckabschnitts dicht an entsprechenden Rundungen in dem Aufnahmeabschnitt an.

Der Aufnahmebereich des Aufnahmeabschnitts 8 ist hier zylindrisch mit einem Innendurchmesser 23 ausgebildet, wie in Fig. 8 gezeigt ist.

Figur 8 zeigt eine alternative Ausgestaltung eines Gehäuses 1 in schematischen Ansichten, wobei hier die Rastnasen 12 an dem Aufnahmeabschnitt 8 vorgesehen sind und dort radial nach innen abstehen. Die Rastöffnungen 13 sind an dem Einsteckabschnitt 7 vorgesehen und dienen zur Aufnahme der Rastnasen 12 im Verbindungszustand 10.

Im Verbindungszustand umgibt der Aufnahmeabschnitt 8 den Einsteckabschnitt 7 im Wesentlichen konzentrisch. Der freie Innendurchmesser 22 zwischen den Rastnasen 12 ist im Verbindungszustand 10 kleiner als der Außendurchmesser 24 des Einsteckabschnitts 7. Im elastisch verformten Öffnungszustand 27 ist der freie Abstand zwischen den Enden der Rastnasen 12 hingegen so groß, dass der Einsteckabschnitt 7 aus dem Aufnahmeabschnitt 8 herausgezogen und somit die beiden Gehäuseteile 3 und 4 voneinander getrennt werden können.

Insgesamt stellt die Erfindung ein einfach montierbares und demontierbares Gehäuse 1 zur Verfügung, welches auch bei hohen Zugkräften eine sichere Verbindung der beiden Gehäuseteile ermöglicht. Dadurch, dass zur Herstellung und zum Lösen der Verbindung wenigstens ein Gehäuseteil von einer runden in eine unrunde Form elastisch überführt werden muss, kann eine sichere und dennoch einfach montierbare Lösung zur Verfügung gestellt werden.

In bevorzugten Ausgestaltungen ist die Rastzone des einen Gehäuseteils geometrisch so geformt, dass alles von einer imaginären Ellipse umfasst wird, deren Umfang etwas kleiner als der Umfang des Innenkreises des äußeren Gehäuseteiles bzw. des Aufnahmeabschnitts entspricht. Durch die Verformung des äußeren Gehäuseteils von der Kreisform zu einem Oval können die Rastnasen eingeführt und somit die Verbindung hergestellt oder die Rastnasen wieder entfernt und somit die Verbindung wieder gelöst werden.

### Bezugszeichenliste

- Gehäuse: 1
- Kabelanschluss: 2
- Gehäuseteil: 3
- Gehäuseteil: 4
- Verbindungsabschnitt: 5
- Verbindungsabschnitt: 6
- Einsteckabschnitt: 7
- Aufnahmeabschnitt: 8
- Einstecköffnung: 9
- Verbindungszustand: 10
- Verrastungsmittel: 11
- Rastnase: 12
- Rastöffnung: 13
- Radiale Richtung: 14
- Axiale Richtung: 15
- Radialer Abstand: 16
- Innenumfang: 17
- Länge: 18
- Maximaler Durchmesser: 19
- Durchmesser: 20
- Freier Durchmesser: 21
- Minimaler freier Durchmesser: 22
- Freier Durchmesser: 23
- Durchmesser: 24
- Schräge: 25
- Umfangsrichtung: 26
- Öffnungszustand: 27
- Werkzeug: 28
- Umhüllende: 29
- Abflachungen: 31, 32
- Radius: 33
- Außendurchmesser: 34
- Innendurchmesser: 35
- Querdurchmesser: 36
- Endbereiche: 37, 38

## Patentansprüche

1. Gehäuse (1), insbesondere für einen elektrischen Kabelanschluss (2), mit zwei miteinander verbindbaren Gehäuseteilen (3, 4), welche jeweils einen Verbindungsabschnitt (5, 6) aufweisen,
wobei ein erstes Gehäuseteil (3) einen als Einsteckabschnitt (7) ausgebildeten Verbindungsabschnitt (5) aufweist,
und wobei ein zweites Gehäuseteil (4) einen als Aufnahmeabschnitt (8) ausgebildeten Verbindungsabschnitt (6) aufweist, wobei der Aufnahmeabschnitt (8) eine Einstecköffnung (9) und einen rundlichen Querschnitt aufweist,
wobei zur Herstellung der Verbindung der Einsteckabschnitt (7) in die Einstecköffnung (9) des zweiten Gehäuseteils (4) einführbar ist, und wobei Verrastungsmittel (11) an den Verbindungsabschnitten (5, 6) vorgesehen sind, welche Rastnasen (12) und Rastöffnungen (13) umfassen, die im Verbindungszustand (10) formschlüssig ineinandergreifen,
**dadurch gekennzeichnet,**
**dass** der Einsteckabschnitt (7) eine von einem runden Querschnitt abweichende Querschnittsform aufweist, und dass der Aufnahmeabschnitt (8) den Einsteckabschnitt (7) im Verbindungszustand (10) radial und axial vollständig und formschlüssig umgibt und dass zur Herstellung des Verbindungszustands (10) der Aufnahmeabschnitt (8) wenigstens teilweise elastisch verformbar ist.

2. Gehäuse nach Anspruch 1, wobei der Aufnahmeabschnitt (8) eine den Einsteckabschnitt (7) umgebende Wand (16) aus einem elastischen Material umfasst.

3. Gehäuse nach Anspruch 1 oder 2, wobei der Aufnahmeabschnitt (8) den Einsteckabschnitt (7) konzentrisch umgibt.

4. Gehäuse nach Anspruch 1, 2 oder 3, wobei der Aufnahmeabschnitt (8) an dem Einsteckabschnitt (7) wenigstens abschnittsweise spielarm und insbesondere spielfrei anliegt.

5. Gehäuse nach einem der vorhergehenden Ansprüche, wobei die wenigstens eine Rastnase (12) an dem Einsteckabschnitt (7) vorgesehen ist und nach außen abstehend ausgebildet ist und wobei die wenigstens eine Rastöffnung (13) an dem Aufnahmeabschnitt (8) vorgesehen ist.

6. Gehäuse nach einem der vorhergehenden Ansprüche, wobei im elastischen Verformungszustand ein Innenumfang (17) des Aufnahmeabschnitts (8) eine Länge (18) aufweist, die mindestens so lang ist wie eine Umhüllende (29) des Einsteckabschnitts (7) mit der wenigstens einen Rastnase (12).

7. Gehäuse nach einem der vorhergehenden Ansprüche, wobei wenigstens zwei gegenüberliegende Rastnasen (12) und wenigstens zwei gegenüberliegende Rastöffnungen (13) vorgesehen sind.

8. Gehäuse nach einem der vorhergehenden Ansprüche, wobei wenigstens eine Rastnase (12) eine Schräge (25) aufweist.

9. Gehäuse nach einem der Ansprüche 1-4 oder 6-8, wobei an dem Einsteckabschnitt (7) wenigstens eine Rastöffnung (13) vorgesehen ist und wobei an dem Aufnahmeabschnitt (8) wenigstens eine nach innen vorstehende Rastnase (12) vorgesehen ist.

10. Gehäuse nach einem der vorhergehenden Ansprüche, wobei der Einsteckabschnitt (7) oder der Aufnahmeabschnitt (8) als Gehäusedeckel ausgebildet ist.

## Claims

1. Housing (1), in particular for an electrical cable connection (2), comprising two housing parts (3, 4) which can be connected to one another and which each have a connecting section (5, 6), wherein a first housing part (3) has a connecting section (5) which is in the form of a plug-in section (7), and wherein a second housing part (4) has a connecting section (6) which is in the form of a receiving section (8), wherein the receiving section (8) has a plug-in opening (9) and a round cross section, wherein the plug-in section (7) can be inserted into the plug-in opening (9) in the second housing part (4) in order to establish the connection, and wherein latching means (11) are provided on the connecting sections (5, 6), the said latching means comprising latching lugs (12) and latching openings (13) which engage one in the other in an interlocking manner in the connected state (10), **characterized in that** the plug-in section (7) has a cross-sectional shape which differs from a round cross section, and **in that** the receiving section (8) surrounds the plug-in section (7) in a radially and axially complete and interlocking manner in the connected state (10), and **in that** the receiving section (8) can be at least partially elastically deformed in order to establish the connected state (10).

2. Housing according to Claim 1, wherein the receiving section (8) comprises a wall (16) which is composed of an elastic material and surrounds the plug-in section (7).

3. Housing according to Claim 1 or 2, wherein the receiving section (8) surrounds the plug-in section (7) in a concentric manner.

4. Housing according to Claim 1, 2 or 3, wherein the receiving section (8) bears against the plug-in section (7) with little play, and in particular without play, at least in sections.

5. Housing according to one of the preceding claims, wherein the at least one latching lug (12) is provided on the plug-in section (7) and is designed so as to protrude outwards, and wherein the at least one latching opening (13) is provided on the receiving section (8).

6. Housing according to one of the preceding claims, wherein, in the elastic deformed state, an inner circumference (17) of the receiving section (8) has a length (18) which is at least as long as an envelope (29) of the plug-in section (7) with the at least one latching lug (12).

7. Housing according to one of the preceding claims, wherein at least two opposite latching lugs (12) and at least two opposite latching openings (13) are provided.

8. Housing according to one of the preceding claims, wherein at least one latching lug (12) has a bevel (25).

9. Housing according to one of Claims 1-4 or 6-8, wherein at least one latching opening (13) is provided on the plug-in section (7), and wherein at least one inwardly projecting latching lug (12) is provided on the receiving section (8).

10. Housing according to one of the preceding claims, wherein the plug-in section (7) or the receiving section (8) is in the form of a housing cover.

## Revendications

1. Boîtier (1), en particulier pour raccordement électrique (2) de câble, présentant deux parties de boîtier (3, 4) aptes à être reliées l'une à l'autre et présentant chacune une section de liaison (5, 6),
une première partie (3) du boîtier présentant une section de liaison (5) configurée comme section d'insertion (7),
une deuxième partie (4) du boîtier présentant une section de liaison (6) configurée comme section de réception (8),
la section de réception (8) présentant une ouverture d'enfichage (9) et une section transversale arrondie,
la section d'enfichage (7) pouvant être insérée dans l'ouverture d'enfichage (9) de la deuxième partie (4) du boîtier pour établir la liaison,
des moyens d'encliquetage (11) étant prévus sur les sections de liaison (5, 6) et comportant des becs d'encliquetage (12) et des ouvertures d'encliquetage (13) qui s'engagent les unes dans les autres en correspondance géométrique en situation de liaison (10),
**caractérisé en ce que**
la section d'enfichage (7) présente une section transversale dont la forme est différente de celle d'une section transversale ronde,
**en ce que** la section de réception (8) entoure complètement, radialement et axialement et en correspondance géométrique la section d'enfichage (7) en situation de liaison (10) et
**en ce que** pour établir la situation de liaison (10), la section de réception (8) peut être déformée élastiquement au moins en partie.

2. Boîtier selon la revendication 1, dans lequel la section de réception (8) comporte une paroi (16) en matériau élastique qui entoure la section d'enfichage (7).

3. Boîtier selon les revendications 1 ou 2, dans lequel la section de réception (8) entoure concentriquement la section d'insertion (7).

4. Boîtier selon les revendications 1, 2 ou 3, dans lequel au moins certaines parties de la section de réception (8) reposent sur la section d'insertion (7) avec peu de jeu et en particulier sans jeu.

5. Boîtier selon l'une des revendications précédentes, dans lequel le ou les becs d'encliquetage (12) sont prévus sur la section d'insertion (7) et sont configurés de manière à déborder vers l'extérieur, la ou les ouvertures d'encliquetage (13) étant prévues sur la section de réception (8).

6. Boîtier selon l'une des revendications précédentes, dans lequel, dans une situation élastiquement déformée, la périphérie intérieure (17) de la section de réception (8) présente une longueur (18) au moins aussi longue qu'une enveloppante (29) de la section d'insertion (7) qui présente le ou les becs d'encliquetage (12).

7. Boîtier selon l'une des revendications précédentes, dans lequel au moins deux becs d'encliquetage (12) opposés et au moins deux ouvertures d'encliquetage (13) opposées sont prévues.

8. Boîtier selon l'une des revendications précédentes, dans lequel au moins un bec d'encliquetage (12) présente une pente (25).

9. Boîtier selon l'une des revendications 1 à 4 ou 6 à 8, dans lequel au moins une ouverture d'encliquetage (13) est prévue sur la section d'enfïchage (7) et au moins un bec d'encliquetage (12) débordant vers l'intérieur est prévu sur la section de réception (8).

10. Boîtier selon l'une des revendications précédentes, dans lequel la section d'enfichage (7) ou la section de réception (8) sont configurées comme couvercle de boîtier.
